# EUROPEAN PATENT SPECIFICATION

(11) **EP 2 610 888 B1**
(45) Date of publication and mention of the grant of the patent: **02.11.2016**
(21) Application number: 13001553.0
(22) Date of filing: 14.06.2010
(51) Int. Cl.: H01J 37/08, H01J 37/02, F25D 3/12, H01J 37/28

(54) **Cooled charged particle systems and methods**
Gekühlte geladene Partikelsysteme und -verfahren
Systèmes de particules chargées refroidies et procédés

(30) Priority: 18.06.2009 US 218282 P
(43) Date of publication of application: 03.07.2013
(62) Divisional of application: 10742622.3
(73) Proprietor: Carl Zeiss Microscopy, LLC, Thornwood, NY 10594 (US)
(72) Inventor: McVey, Shawn, Newton, NH 03858 (US); Dimanna, Mark, Newton, NH 03858 (US); Bassett, Brian, South Hampton, NH 03827 (US); Comunale, Richard, Ipswich, MA 01938 (US); Barriss, Louise, North Reading, MA 01864 (US); Sanford, A. Colin, Atkinson, New Hampshire 03811 (US); Notte, A. John, Gloucester, MA 01930-5113 (US); Groholski, Alexander, Salem, MA 01970 (US)
(74) Representative: Carl Zeiss AG - Patentabteilung

(56) References cited:
- EP-A1- 2 031 633
- JP-A- 63 175 318
- US-A- 3 702 932
- US-A- 3 745 785
- US-A- 4 489 569
- US-A- 5 119 637
- US-A- 5 385 027
- US-A1- 2002 130 278
- US-A1- 2006 101 832
- US-A1- 2007 245 749
- US-A1- 2009 152 462
- US-A1- 2009 173 888
- US-A1- 2011 147 609
- LEVI-SETTI RICCARDO: "HIGH-RESOLUTION SCANNING TRANSMISSION LOW-ENERGY ION MICROSCOPES AND MICROANALYZERS", ADVANCES IN ELECTRONICS AND ELECTRON PHYSICS, ACADEMIC PRESS INC., NEW YORK, NY, US, no. SUPPLEMENT 13A, 1 January 1980 (1980-01-01), pages 261-320, XP009073485, ISSN: 0065-2539

## Description

### METHOD FOR OPERATING A DEWAR

### Field

The disclosure generally relates to cooling methods.

### Background

Charged particle sources, such as ion beam sources and electron beam sources, can be used to investigate and/or modify a sample. In many instances, such charged particle sources are cooled during use by thermally coupling the charged particle source to a cryogen, such as liquid nitrogen.

US 5385027 A discloses a device and a method for cryogenic refrigerating of an object in which a pressure reduction causes solidification of a cryogen.

### Summary

The present invention is defined in claim 1. Preferred embodiments are set out in the dependent claims.

The disclosure provides methods for cooling a charged particle source to desirably low temperatures, such as for example 80K or below. The methods can be implemented such that these low temperatures are maintained during use of the charged particle source. In some cases, the methods for cooling the charged particle source provide little or no contribution to vibration of the charged particle source.

According to the method according to the invention as claimed, a solid, such as solid nitrogen, is used as a cryogen to cool the charged particle source. Using a solid cryogen can be advantageous because the boiling of a liquid cryogen can contribute to vibration of a charged particle source, whereas a solid such as frozen nitrogen avoids this issue. Further, a solid cryogen can be cooled to lower temperatures than a corresponding liquid cryogen. For example, liquid nitrogen generally attains a temperature of 77K, whereas solid nitrogen can be maintained at substantially lower temperatures, such as 65K and below. Thus, using a solid nitrogen can also result in the possibility of maintaining a lower charged particle source temperature. This can be desirable because in many systems the charged particle current scales roughly as the inverse of the charge particle source temperature.

The method according to the invention includes further measuring a temperature of a region of a dewar near a bottom of the dewar, determining whether the temperature of the region of the dewar near the bottom of the dewar is at or above a target temperature, and adding a liquid cryogen to the dewar if the temperature of the region of the dewar near the bottom of the dewar is at or above the target temperature. After adding the liquid cryogen to the dewar the method according to the invention further comprises a step of reducing a gas pressure in the dewar (210) to solidify the cryogen.

The method according to the invention can include, if the temperature of the region of the dewar near the bottom of the dewar is below the target temperature, heating the dewar. Heating the dewar can change a state of solid cryogen in the dewar to a liquid or a gas.

The method according to the invention can include, if the temperature of the region of the dewar near the bottom of the dewar is above the target temperature, waiting a period of time, and, after waiting the period of time, measuring a first temperature of the region of the dewar near the bottom of the dewar. The period of time can be at least one minute (e.g., at least two minutes, at least five minutes, at least ten minutes, at least 15 minutes, at least 20 minutes, at least 25 minutes, at least 30 minutes, at least 40 minutes, at least 50 minutes, at least 60 minutes, at least 70 minutes, at least 80 minutes, at least 100 minutes, at least 120 minutes).

The liquid cryogen can be liquid nitrogen and the target temperature can be 77K.

In general, in a first aspect, the disclosure features systems that include a charged particle source, a dewar configured to house a cryogen, and a thermal conductor that thermally connects the charged particle source and the dewar so that, during use of the charged particle source when the cryogen is in the dewar, the charged particle source can be maintained at a temperature of 80K or less.

In another aspect, the disclosure features systems that include a charged particle source, a dewar configured to house a cryogen, means for enhancing thermal contact between the dewar and a cryogen disposed in the dewar, and a thermal conductor that thermally connects the charged particle source and the dewar.

In a further aspect, the disclosure features systems that include a charged particle source, a dewar configured to house a cryogen, the dewar including walls with inwardly extending fins that contact the cryogen, and a thermal conductor that thermally connects the charged particle source and the dewar.

In another aspect, the disclosure features systems that include a charged particle source, a dewar configured to house a cryogen, and a thermal conductor that thermally connects the charged particle source and the dewar so that, a period of time between when the cryogen in a liquid state is added to the dewar and when the charged particle source reaches a temperature of 80K or less in three hours or less.

In a further aspect, the disclosure features systems that include a charged particle source, a dewar configured to house a cryogen, the dewar including sensors configured to determine a temperature of the cryogen, and a thermal conductor that thermally connects the charged particle source and the dewar.

Examples of the methods can include one or more of the following features.

The charged particle source can be a gas field ion source. The charged particle source can be an electron source.

The cryogen can include solid nitrogen. The cryogen can include solid neon or solid argon.

The dewar can include means for enhancing thermal contact between the cryogen and the dewar. The dewar can include walls with inwardly extending fins that contact the cryogen.

The thermal conductor can be configured to allow the charged particle source to be tilted. The thermal conductor can vibrationally isolate the charged particle source from the dewar. The thermal conductor can include flexible braids.

The dewar can include sensors configured to determine a state of the cryogen. The dewar can include sensors configured to determine a temperature of the cryogen. The dewar can include sensors configured to determine a level of cryogen in the dewar.

The dewar can include sensors configured to determine a cryogen parameter, and a system can include a feedback system configured to adjust an amount of cryogen in the dewar based on the determined cryogen parameter. The cryogen parameter can include a parameter selected from the group consisting of a state of cryogen in the dewar, a level of cryogen in the dewar, a temperature of cryogen in the dewar, and a mass of cryogen in the dewar.

The dewar can include at least one heater configured to heat the dewar. The at least one heater can be configured to heat the cryogen.

The dewar can include an outer thermal jacket configured to thermally isolate the cryogen from an environment exterior to the dewar. The at least one heater can be configured to heat an interior of the outer thermal jacket.

A system for carrying out the method according to the invention can include a pump configured to pump gas from an interior of the outer thermal jacket. The system can include a sensor configured to sense a gas pressure in the interior of the outer thermal jacket. After turning off the pump, a pressure in the outer thermal jacket may not change by more than 10% for a least one day. The pump can also be configured to pump a volume adjacent the charged particle source.

The system can include a valve configured to isolate the interior of the outer thermal jacket from the volume adjacent the charged particle source. The charged particle source can be maintained at a temperature of 80K or less for at least one hour.

The sensors can be configured to determine a level of the cryogen in the dewar. Alternatively, or in addition, the sensors can be configured to determine a state of the cryogen in the dewar. Alternatively, or in addition, the sensors can be configured to determine a temperature of the cryogen in the dewar.

The system can include a feedback system coupled to the sensors so that the feedback system can adjust an amount of the cryogen in the dewar based on a signal from the sensors. The sensors can be configured to determine a cryogen parameter, and the signal can carry information regarding the cryogen parameter. The cryogen parameter can include a parameter selected from the group consisting of a state of cryogen in the dewar, a level of cryogen in the dewar, and a temperature of cryogen in the dewar.

### Brief Description of the Drawings

Fig. 1 is a schematic representation of a system including a gas field ion source thermally coupled to a dewar containing a cryogen;
Fig. 2 is schematic cross-sectional view of a dewar for housing a cryogen;
Fig. 3 is a flow chart of a method of re-filling a dewar with liquid cryogen;
Fig. 4 is a schematic cross-sectional view of a dewar and elements of a feedback loop;
Fig. 5 is a schematic cross-sectional view of a dewar having fins on its inner walls;
Fig. 6 is a schematic cross-sectional view of an outer jacket of a dewar having heaters;
Fig. 7 is a schematic cross-sectional view of a dewar with a single pump that pumps an outer jacket and an interior volume of the dewar;
Fig. 8 is a schematic cross-sectional view of a dewar with a single pump that pumps a gas field ion source and an outer jacket of the dewar;
Fig. 9 is a schematic cross-sectional view of a dewar with a single pump that pumps a gas field ion source and an interior volume of the dewar;
Fig. 10 is a schematic cross-sectional view of a dewar with a single pump that pumps a gas field ion source, an outer jacket of the dewar, and an interior volume of the dewar;
Fig. 11 is a schematic view of a gas field ion microscope;
Fig. 12 is a schematic cross-sectional view of a portion of a gas field ion source coupled to a dewar with flexible contact members;
Fig. 13 is a schematic view of a thermal coupling mechanism.

### Detailed Description

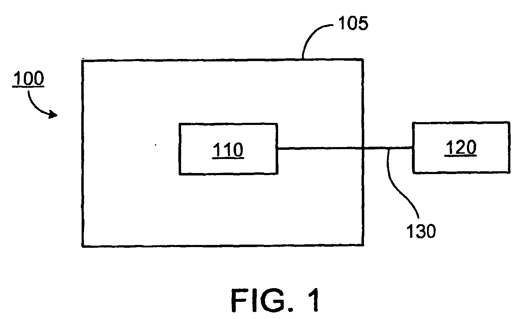

Fig. 1 shows a system 100 that includes a housing 105 and a gas field ion source (GFIS) 110 in housing 105. System 100 also includes a dewar 120 containing solid nitrogen as a cryogen, which is thermally coupled to gas field ion source 110 via a thermal conduit 130. With this design, the solid nitrogen can be used to maintain a relatively low temperature of GFIS 110, which can enhance the ion current generated by GFIS.

In some examples, during operation of GFIS 110, its temperature can be 80K or less (e.g., 75K or less, 70K or less, 65K or less, 60K or less) for a relatively long period of time (e.g., at least one hour, at least five hours, at least 10 hours, at least 15 hours, at least 20 hours, at least 25 hours, at least 30 hours).

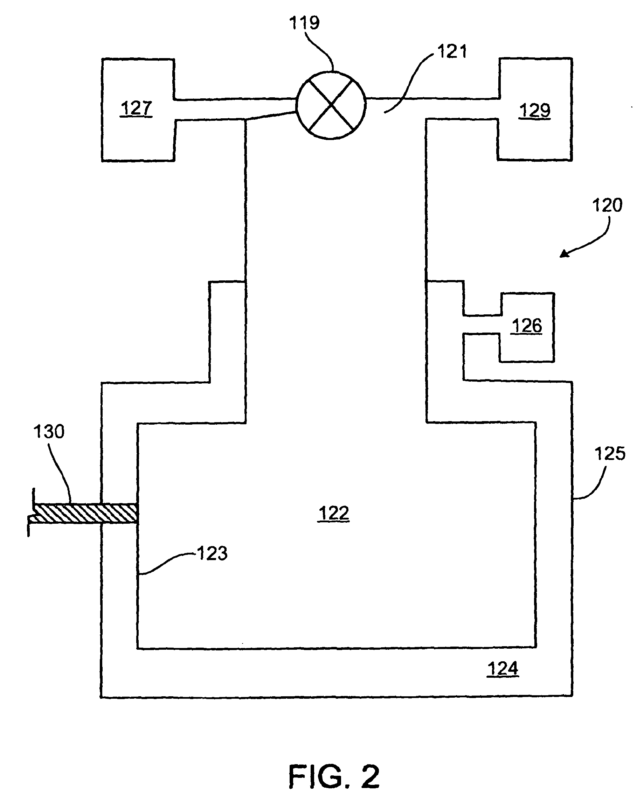

Fig. 2 is a cross-section view of dewar 120 having an orifice 121 to an interior volume 122 for housing the solid nitrogen. Dewar 120 includes an outer jacket 124 defined by walls 123 and 125. A portion of thermal conduit 130 extends through wall 125 and is thermally coupled to wall 123. In some examples thermal conduit 130 can be thermally coupled to other portions of dewar 120 such as the bottom of outer jacket 124 instead of, or in addition to, being thermally coupled to wall 123.

A pump 126 is configured to form a vacuum in outer jacket 124 to reduce undesired thermal coupling between interior volume 122 and the region exterior to wall 125. In some examples, pump 126 may be able to attain a pressure of 1x10⁻⁴ Torr or less (e.g., 1x10⁻⁵ Torr or less, 1x10⁻⁶ Torr or less, 1x10⁻⁷ Torr or less, 1x10⁻⁸ Torr or less, 1x10⁻⁹ Torr or less) in outer jacket 124. In certain examples, pump 126 can be turned off for an extended period of time (e.g., at least one day, at least three days, at least five days) with little or no change (e.g., less than 10% change, less than 5% change, less than 1% change) in the pressure in outer jacket 124.

A pump 127 and a liquid nitrogen source 129 are connected to interior volume 122 via orifice 121. Pump 127 and liquid nitrogen source 129 can be isolated from each other with a valve 119. For example, valve 119 can be configured so that pump 127 is isolated from interior volume 122 while source 129 supplies liquid nitrogen to interior volume 122. As another example, valve 119 can be configured so that source 129 is isolated from interior volume 122 while pump 127 is used to reduce the pressure of interior volume 122. In some cases, valve 119 is configured to isolate volume 122 from both pump 127 and source 129.

In certain examples multiple valves can be used rather than a single valve 119. For example, a first valve can be used to isolate or connect pump 127 to interior volume 122, and a second valve can be used to isolate or connect source 129 to interior volume 122. The two valves can be operated independently. Further, in some examples more than one valve can be used to isolate or connect either or both of pump 127 and source 129 to interior volume 122. For example, two valves can be interposed between source 129 and interior volume 122. The use of two valves to either connect or isolate source 129 (or pump 127) to/from interior volume 122 provides a safety mechanism in the event that either of the valves fails, or opens inadvertently.

Typically, providing solid nitrogen to dewar 120 involves first supplying liquid nitrogen to interior region 122 via source 129 while valve 119 isolates pump 127 from interior volume 122. After an appropriate amount of liquid nitrogen is supplied to interior volume 122, valve 119 isolated source 129 from interior volume 122, and valve 119 is configured so that pump 127 can reduce the pressure of interior volume 122, thereby transforming the liquid nitrogen to solid nitrogen.

Applicants discovered that in some cases re-filling dewar 120 with liquid nitrogen can be complicated because, even though the nitrogen near the bottom of the dewar has sublimed, solid nitrogen (e.g., in the form of a sheet that extends at least partially across a lateral portion of interior volume 121) may be present in dewar 120 and may interfere with re-filling dewar 120. When this occurs, liquid nitrogen poured into interior volume 122 of dewar 120 may not be able to reach the bottom of interior volume 122 (e.g., because it is blocked by a sheet of solid nitrogen), and subsequent transformation of the liquid to solid may not effectively cool charged particle source 110 in the desired fashion. As disclosed above, in some examples, thermal conduit 130 is coupled to the bottom of outer jacket 124; if the liquid nitrogen that is introduced cannot reach the bottom of interior volume 122 and freeze, thermal conduit 130 does provide as efficient a cooling path for excess heat from the charged particle source. Thus, for example, in some instances it may not be enough to simply measure the amount of solid nitrogen (e.g., by sensing the weight of solid nitrogen) because, even if the amount of solid nitrogen is at a level that indicates re-filling interior volume 122 of dewar 120 with liquid nitrogen is appropriate, the above-noted blockage problem may be present, and attempting to re-fill interior volume 122 may not actually result in re-filling interior volume 122.

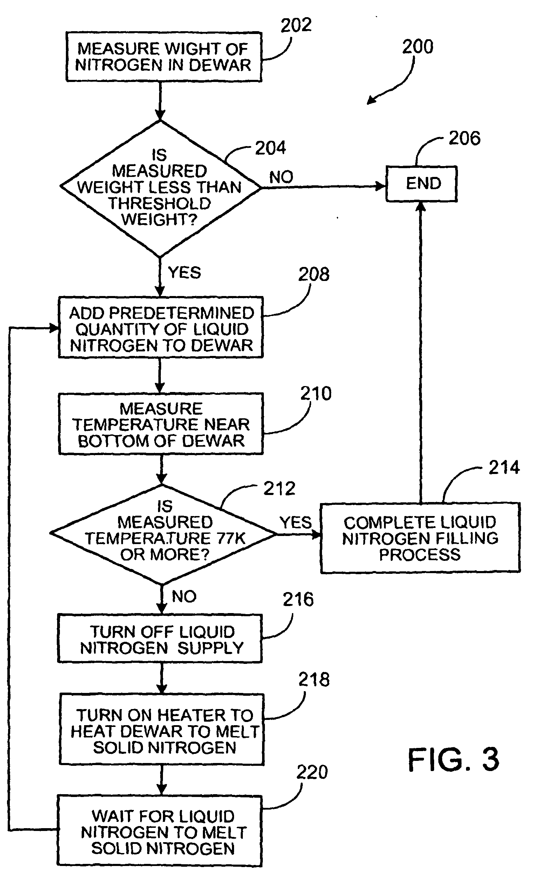

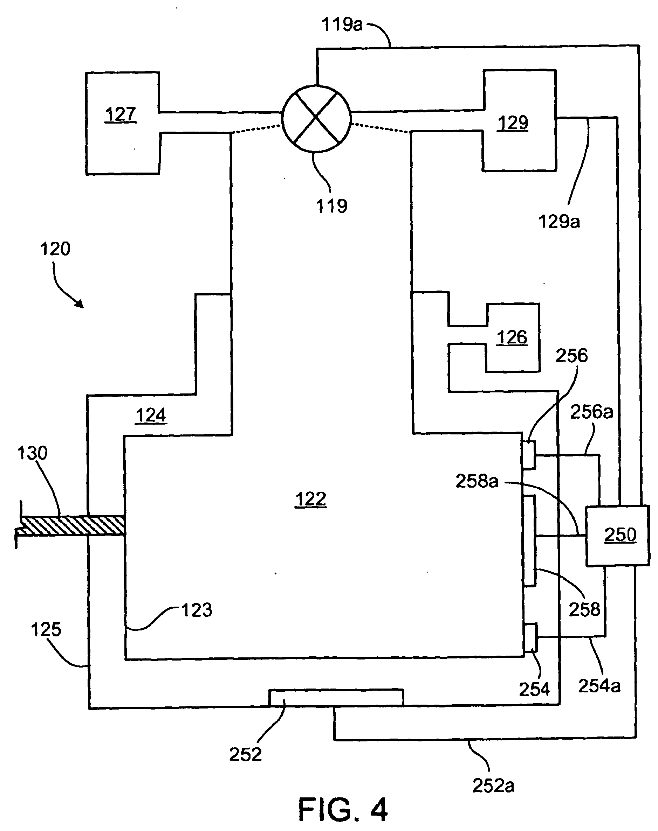

Accordingly, in some examples, re-filling interior volume 122 of dewar 120 is achieved as follows. Fig. 3 shows a flow chart 200 that includes a series of steps that can be used to implement a filling procedure for dewar 120. Fig. 4 shows a schematic diagram of dewar 120 that includes, in addition to the various components already discussed above and bearing the same reference identifiers, a weight sensor 252, a temperature sensor 254, a fill sensor 256, and a heater 258. Sensors 252, 252, 254, and heater 258 are electrically connected to controller 250 via communication lines 252a, 254a, 256a, and 258a, respectively. Valve 119 is electrically connected to controller 250 via communication line 119a, and source 129 is electrically connected to controller 250 via communication line 129a. Referring to Fig. 3, the amount of solid nitrogen present in dewar 120 is measured (e.g., using weight sensor 252, using fill sensor 256, or by measuring a time interval since dewar 120 was last filled with nitrogen) in step 202, and the result of the measurement is transmitted to an electronic processor (e.g., controller 250). In step 204, the electronic processor compares the amount of nitrogen in dewar 120 (e.g., determined or estimated from a measured weight of nitrogen in dewar 120, a measured height of liquid nitrogen in dewar 120, or an elapsed time since dewar 120 was last filled) to a

predetermined amount (e.g., a threshold value). If the amount of nitrogen in dewar 120 is greater than the predetermined threshold amount (e.g., the measured weight is larger than a weight threshold value and/or a measured height of liquid nitrogen is larger than a threshold height value and/or an elapsed time since dewar 120 was last filled is less than a threshold time interval), then the re-fill procedure is terminated in step 206.

Alternatively, if the amount of nitrogen in dewar 120 is below the predetermined threshold amount, controller 250 opens valve 119 between region 122 of dewar 120 and source 129 to introduce a limited amount of liquid nitrogen into dewar 120 in step 208 of the procedure. If the temperature of dewar 120 is significantly larger than 77 K (e.g., when dewar 120 is approximately at room temperature, or when dewar 120 has warmed up a temperature more than a few degrees above 77 K), then small amounts of liquid nitrogen can be introduced into dewar 120 at intervals over a period of several minutes. By introducing liquid nitrogen in this manner, violent boiling of the liquid nitrogen in dewar 120 may be reduced and/or avoided. Once the temperature of dewar 120 has been lowered sufficiently so that violent boiling of liquid nitrogen is reduced or eliminated, valve 119 can be opened by controller 250 to complete addition of liquid nitrogen to dewar 120.

Next, in step 210, the temperature of a region near the bottom of dewar 120 is measured with a sensor (e.g., sensor 254, which can include one or more cryodiodes) and the temperature measurement is communicated to controller 250. Based on the signal sent to controller 250 by sensor 254, controller 250 can open or close valve 119 to either add more liquid nitrogen from source 129 to dewar 120 or not. In step 212, if the signal from sensor 254 indicates that the temperature near the bottom of dewar 120 is approximately 77K or above (the melting temperature of liquid nitrogen), then controller 250 completes the liquid nitrogen filling process in step 214 by maintaining valve 119 in an open position so that liquid nitrogen from source 129 is introduced into dewar 120. The filling process is monitored via fill sensor 256, which transmits signals to controller 250 to indicate the nitrogen level in dewar 120. When sensor 256 detects that the liquid nitrogen has reach a certain level in dewar 120, controller 250 closes valve 119, and the filling process terminates at step 206.

If, however, the signal from sensor 254 indicates that the temperature near the bottom of dewar 120 is less than approximately 77K (and, in some examples, if it has been less than a predetermined period (e.g., 12 hours) since dewar 120 was last filled with liquid nitrogen), then controller 250 will not complete the liquid nitrogen filling process. Instead, in step 216, controller 250 closes valve 119 to discontinue filling dewar 120 with liquid nitrogen from source 129. Optionally, in step 218, controller 250 can turn on a heater (e.g., heater 258) that can heat wall 123 to melt solid nitrogen that may be preventing liquid nitrogen from reaching the bottom of dewar 120. Heater 258 can be turned on for an appropriate period of time (e.g., one minute or more, two minutes or more, five minutes or more, ten minutes or more, 15 minutes or more, 20 minutes or more, 30 minutes or more, 40 minutes or more, 60 minutes or more) so that some or all of the solid nitrogen in dewar 120 melts. During the period during which dewar 120 is heated, heater 258 can supply one watt or more of power (e.g., two watts or more, five watts or more, ten watts or more, 15 watts or more, 20 watts or more, 30 watts or more, 40 watts or more, 60 watts or more, 80 watts or more, 100 watts or more) to heat dewar 120.

Optionally, in step 220, controller 250 can wait for the liquid nitrogen introduced in step 208 to melt some or all of the solid nitrogen in dewar 120. As a further option in step 220, controller 250 can open valve 119 to introduce a further predetermined quantity of liquid nitrogen into dewar 120 to melt solid nitrogen. Controller 250 can typically wait in step 220 for a period of 1 minute or more (e.g., 2 minutes or more, 5 minutes or more, 10 minutes or more, 15 minutes or more, 20 minutes or more, 30 minutes or more, 40 minutes or more, 50 minutes or more, 60 minutes or more, 90 minutes or more, 120 minutes or more) for the liquid nitrogen to melt solid nitrogen in dewar 120.

Either of steps 218 and 220 can optionally be performed, and in some examples, both steps can be performed. In certain examples, neither step is performed. By performing either or both of steps 218 and 220, solid nitrogen in dewar 120 is melted to form liquid nitrogen. As the solid nitrogen melts, the temperature of dewar 120 increases, and the increase is monitored by controller 250 via temperature sensor 254. When dewar 120 has warmed up so that the solid nitrogen in dewar 120 has melted, fill sensor 256 measures the liquid nitrogen level in dewar 120. If dewar 120 is not full, controller 250 can subsequently return to step 208 in the nitrogen filling process, in which controller 250 opens valve 119 to introduce a limited amount of liquid nitrogen is into dewar 120. Steps 210 and 212 are then repeated to measure the temperature near the bottom of dewar 120 using sensor 254, and to decide whether to continue or discontinue filling dewar 120 based on the temperature measurement. Finally, after the filling process shown in FIG. 3 is complete in step 206, controller 250 can adjust valve 119 so that pump 127 is in communication with interior volume 122 of dewar 120 (or, when two valves are used, controller 250 can close the valve between source 129 and interior volume 122, and open the valve between pump 127 and interior volume 122). Controller 250 can then activate pump 127 to convert liquid nitrogen in dewar 120 to solid nitrogen.

In some examples, weight sensor 252 can be used, in place of or in combination with, fill sensor 256 to determine the amount of cryogen in dewar 120, and when to stop adding additional liquid cryogen. For example, the amount of liquid and/or solid cryogen in dewar 120 can be determined directly from mass measurements by sensor 252. Furthermore, the amount of liquid cryogen added to dewar 120 as the dewar is filled can be determined by sensor 252, which monitors the total mass of cryogen in the dewar during addition of liquid cryogen. Accordingly, measurements of the mass of cryogen in dewar 120 can be used together with, or in place of, fill-level measurements in any one or more of the steps shown in FIG. 3.

In certain examples, there can be a relatively short period of time from when liquid nitrogen is added to dewar 120 and when charged particle source 110 reaches a temperature of 80K or less (e.g., 75K or less, 70K or less, 65K or less). For example, in some examples, this period of time is less than three hours (e.g., less than two hours, less than 90 minutes, less than one hour, less than 30 minutes, less than 15 minutes, less than 10 minutes).

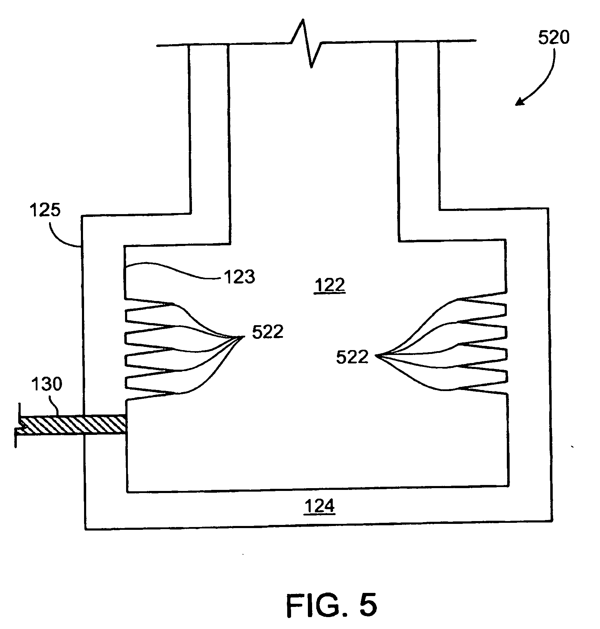

In general, it is desirable to maintain good thermal contact between the solid nitrogen and wall 123 so that there is good thermal coupling between the solid nitrogen and thermal conduit 130. Applicants realized that in some cases as the solid nitrogen undergoes sublimation, a gap may develop between the solid nitrogen and wall 123. Therefore, in certain examples, dewar 120 may include one or more mechanisms to enhance adhesion of the solid nitrogen to wall 123. As an example, Fig. 5 shows a dewar 520 in which wall 123 has inwardly extending fins 522. Fins 522 help to prevent formation of gaps between solid nitrogen in interior volume 122 and wall 123.

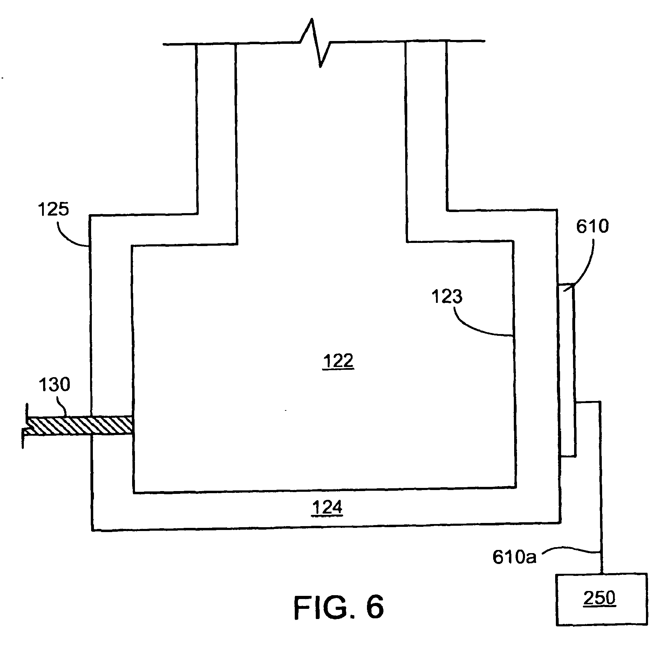

Usually, it is desirable to try to minimize condensation of water within outer jacket 124 because such condensed water can provide a thermal short between the solid nitrogen in interior volume 122 and the region exterior to wall 125. Accordingly, referring to Fig. 6, one or more heaters 610 may be in thermal contact with wall 125 to heat condensed water in outer jacket 124 so that the condensed water transforms to a gas and is pumped out of outer jacket 124. The one or more heaters 610 can be electrically connected to controller 250 via communication lines 610a, for example. Additionally or alternatively, one or more heaters can be present on wall 123 to address the issue of condensed water.

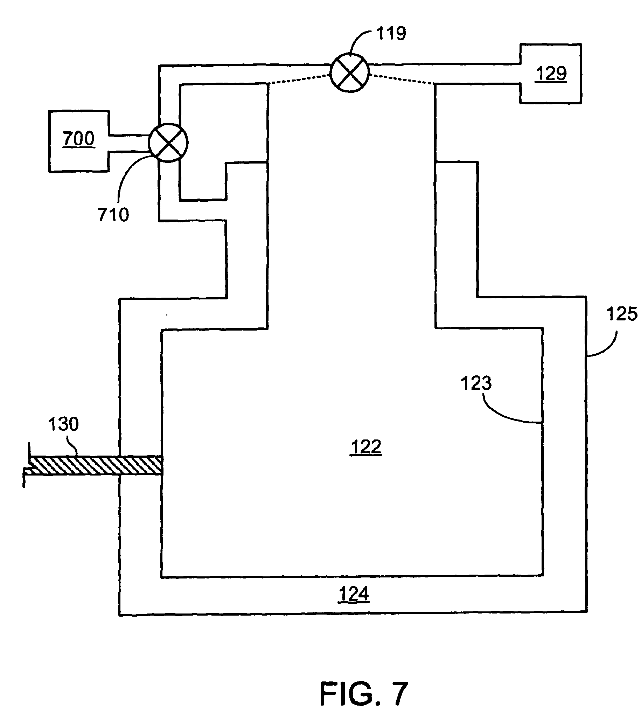

In some cases, it can be desirable to use the same pump to pump for multiple purposes. Fig. 7 shows a system in which a pump 700 is used instead of separate pumps 126 and 127 (e.g., as shown in Fig. 4). A valve 710 can be used for desired isolation of components of the system. For example, valve 710 can be configured to isolate pump 700 from interior volume 122 while allowing pump 700 to reduce the pressure of outer jacket 124. As another example, valve 710 can be configured to allow pump 700 to reduce the pressure in interior volume 122 while isolating pump 700 from outer jacket 124. As a further example, valve 710 can be configured to allow pump 700 to simultaneously pump on both outer jacket 124 and interior volume 122. As an additional example, valve 710 can be configured to isolate pump 700 from both outer jacket 124 and interior volume 122.

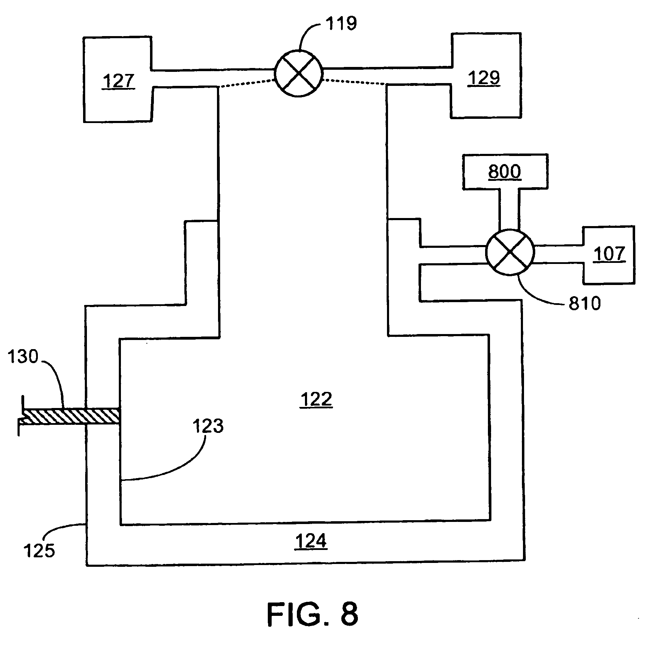

A common pump can be used to evacuate different portions of the system. For example, Fig. 8 shows an example of a system that includes a pump 800 that can create a reduced-pressure environment in gas field ion microscope 107 (e.g., including a gas field ion source and, in some examples, other components such an ion column and a particle chamber), and in outer jacket 124. Valve 810 can be configured to isolate pump 800 from outer jacket 124 while allowing pump 800 to reduce the pressure in gas field ion microscope 107. Alternatively, valve 810 can be configured to isolate pump 800 from gas field ion microscope 107 while allowing pump 800 to reduce the pressure in outer jacket 124. In some examples, valve 810 can be configured to allow pump 800 to reduce the pressure in both gas field ion microscope 107 and outer jacket 124. In certain examples, valve 810 can be configured to completely isolate pump 800 from both gas field ion microscope 107 and outer jacket 124.

In certain examples, when a single pump is used to reduce pressure in both a region of dewar 120 (e.g., interior volume 122 and/or outer jacket 124) and in gas field ion microscope 107, it may be advantageous to connect the pump to a particular component of the gas field ion microscope. For example, to avoid contamination of the gas field ion source, it may be advantageous in certain examples to connect the pump to a different component of gas field ion microscope 107 such as an ion column. By connecting the pump to the ion column, it may be possible to ensure that a useful lifetime of the tip in the gas field ion source is extended relative to the lifetime when the gas field ion source is connected to the pump. More generally, however, the pump can, as desired, be connected to any one or more of the various components in gas field ion microscope 107, including any one or more of the microscope's gas field ion source, ion column, and particle chamber.

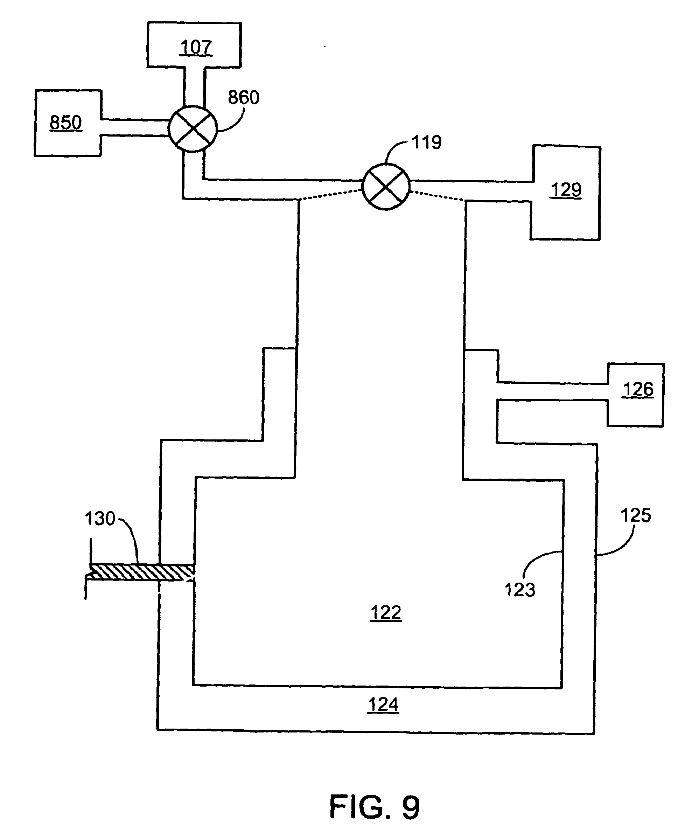

Fig. 9 shows an example of a system that includes a pump 850 that can create a reduced-pressure environment in gas field ion microscope 107 (e.g., including a gas field ion source and, in some examples, other components such an ion column and a particle chamber), and in interior volume 122. Valve 860 can be configured to isolate pump 850 from interior volume 122 while allowing pump 850 to reduce the pressure in gas field ion microscope 107. Alternatively, valve 860 can be configured to isolate pump 850 from gas field ion microscope 107 while allowing pump 850 to reduce the pressure in interior volume 122. In some examples, valve 860 can be configured to allow pump 850 to reduce the pressure in both gas field ion microscope 107 and interior volume 122. In certain examples, valve 860 can be configured to completely isolate pump 850 from both gas field ion microscope 107 and interior volume 122.

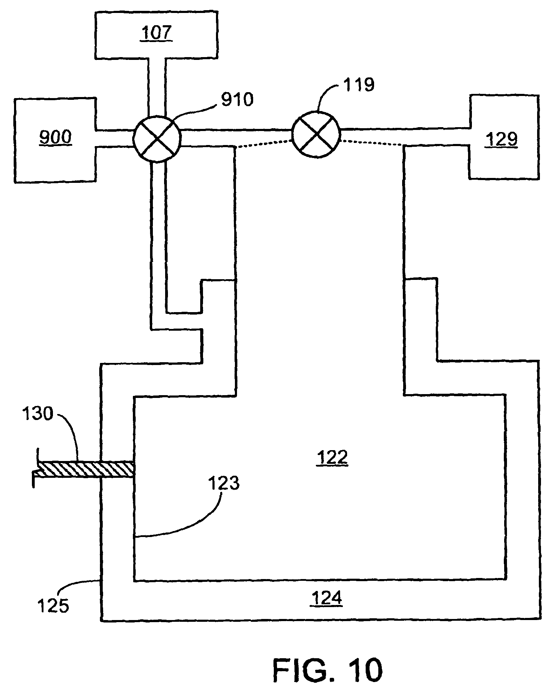

Fig. 10 shows an example of a system that includes a pump 900 that can create a reduced-pressure environment in gas field ion microscope 107 (e.g., including a gas field ion source and, in some examples, other components such an ion column and a particle chamber), in interior volume 122, and in outer jacket 124. Valve 910 can be configured to allow pump 900 to reduce the pressure in any one of gas field ion microscope 107, interior volume 122, and outer jacket 124, while isolating pump 900 from the other portions of the system. Alternatively, valve 910 can be configured to allow pump 900 to reduce the pressure in any two of gas field ion microscope 107, interior volume 122, and outer jacket 124, while isolating pump 900 from the other portions of the system. In some examples, valve 910 can be configured to allow pump 900 to reduce the pressure in each of gas field ion microscope 107, interior volume 122, and outer jacket 124. In certain examples, valve 910 can be configured to completely isolate pump 900 from gas field ion microscope 107, interior volume 122, and outer jacket 124.

In some examples, a single pump can be used to reduce pressure in one or more components of dewar 120, and one or more additional pumps can be used to reduce pressure in other components of dewar 120. For example, in certain examples, a single pump can be used to reduce pressure in both outer jacket 124 and in interior volume 122 or, for example, in an ion column of gas field ion microscope 107. A second pump can be used to pump liquid nitrogen into interior volume 122.

Typically, gas ion beams are produced in multipurpose microscope systems such as gas field ion microscopes. A gas field ion source is a device that includes a tip (typically having an apex with 10 or fewer atoms) that can be used to ionize neutral gas species to generate ions (e.g., in the form of an ion beam) by bringing the neutral gas species into the vicinity of the tip (e.g., within a distance of about four to five angstroms) while applying a high positive potential (e.g., one kV or more relative to the extractor (see discussion below)) to the apex of the electrically conductive tip.

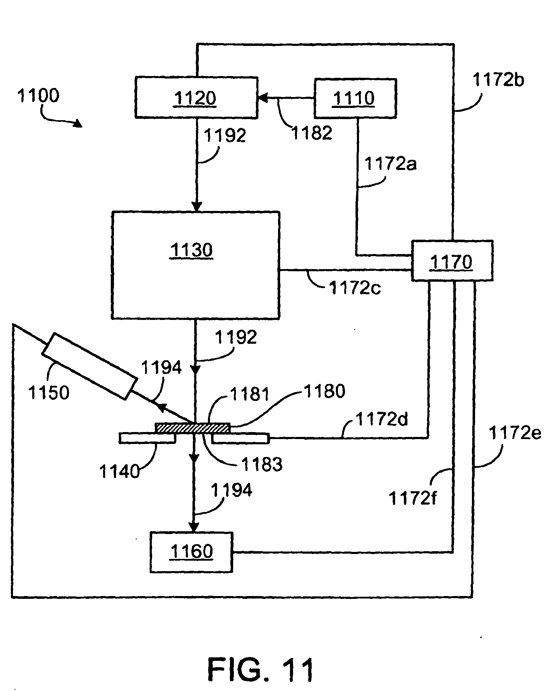

Fig. 11 shows a schematic diagram of a gas field ion microscope system 1100 that includes a gas source 1110, a gas field ion source 1120, ion optics 1130, a sample manipulator 1140, a front-side detector 1150, a back-side detector 1160, and an electronic control system 1170 (e.g., an electronic processor, such as a computer) electrically connected to various components of system 1100 via communication lines 1172a-1172f. A sample 1180 is positioned in/on sample manipulator 1140 between ion optics 1130 and detectors 1150, 1160. During use, an ion beam 1192 is directed through ion optics 1130 to a surface 1181 of sample 1180, and particles 1194 resulting from the interaction of ion beam 1192 with sample 1180 are measured by detectors 1150 and/or 1160.

In general, it is desirable to reduce the presence of certain undesirable chemical species in system 1100 by evacuating the system. Typically, different components of system 1100 are maintained at different background pressures. Gas source 1110 is configured to supply one or more gases to gas field ion source 1120. The gases can be supplied at a variety of purities, flow rates, pressures, and temperatures. In general, at least one of the gases supplied by gas source 1110 is a noble gas (helium (He), neon (Ne), argon (Ar), krypton (Kr), xenon (Xe)), and ions of the noble gas are desirably the primary constituent in ion beam 1192.

Gas field ion source 1120 is configured to receive gases from gas source 1110 and to produce gas ions from the gases in the vicinity of the tip. The tip can be formed of various materials, such as one or more metals (e.g., tungsten (W), tantalum (Ta), iridium (Ir), rhenium (Rh), niobium (Nb), platinum (Pt), molybdenum (Mo)) and/or alloys and/or different materials such as carbon.

During use, the tip is biased positively so that the electric field of the tip at its apex points outward from the surface of the tip apex. Due to the shape of the tip, the electric field is strongest in the vicinity of the tip apex. Un-ionized gas atoms supplied by gas source 1110 are ionized and become positively-charged ions in the vicinity of the tip apex. The ions are directed from the tip into ion optics 1130 as ion beam 1192. Ion optics 1130 are configured to direct ion beam 1192 onto surface 1181 of sample 1180. Ion optics 1130 can, for example, focus, collimate, deflect, accelerate, and/or decelerate ions in beam 1192. Generally, ion optics 1130 include a variety of electrostatic and other ion optical elements that are configured as desired. By manipulating the electric field strengths of one or more components (e.g., electrostatic deflectors) in ion optics 1130, He ion beam 1192 can be scanned across surface 1181 of sample 1180. For example, ion optics 1130 can include two deflectors that deflect ion beam 1192 in two orthogonal directions. The deflectors can have varying electric field strengths such that ion beam 1192 is rastered across a region of surface 1181. Other features of ion beam systems are disclosed, for example, in U.S. Patent No. 7,504,639, the entire contents of which are incorporated herein by reference.

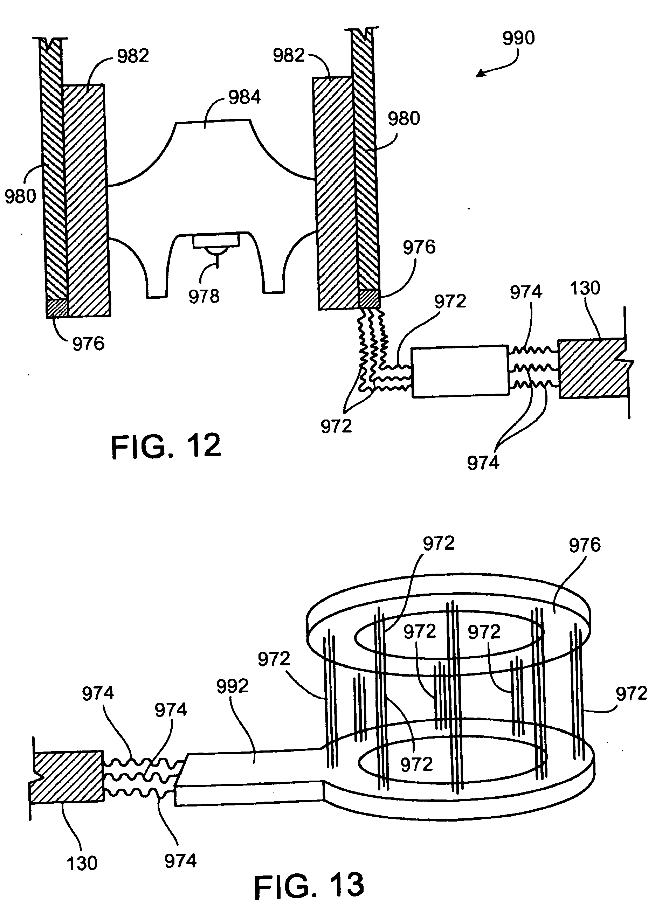

Dewar 120 can be coupled to gas field ion source 110 in a variety of different ways. Fig. 12 shows an example of a system 990 in which dewar 120 can be coupled via thermal conduit 130 to the gas field ion source via an intermediate support 976. System 990 includes a housing 980 that encloses supporting members 982 and 984. Tip 978 is positioned on supporting member 984, and is in thermal contact with dewar 120 via intermediate support 976. A first
plurality of flexible contact members 972 that connect intermediate support 976 to central member 970. A second plurality of flexible contact members 974 connect central member 970 to thermal conduit 130. One central member 970 is shown in Fig. 12 but in general, any number (e.g., two or more, three or more, four or more, or even more) of central members 970 can be used.

Contact members 972 and 974, and central member 970, provide a path for heat transfer between thermal conduit 130 and intermediate support 976. Flexible contact members 972 and 974 and central member 970 are typically formed from one or more materials with relatively high thermal conductivity, such as copper. Other materials from which some or all of contact members 972 and 974 and central member 970 can be formed include carbon-based materials such as carbonaceous pitch, silver, and/or gold. In some examples, for example, flexible contact members 972 and/or 974 can be formed from large numbers of small diameter, flexible strands of one or more thermally conductive materials such as copper, that are woven and/or wrapped around one another to form rope-like braids corresponding to contact members 972 and/or 974.

The combination of flexible contact members 972 and 974 and central member 970 functions as a vibration damper, reducing the amplitude of vibrations transmitted to tip 978. By forming contact members 972 and 974 from flexible materials, vibration transfer through these materials is reduced relative to vibration transfer through more rigid materials. Further, central member 970 acts as a type of pendulum to counteract vibrations that are coupled into the flexible contact members. In some examples, either or both of contact members 972 and 974 can include other features such as U-shape bends and/or axial rotations (e.g., inherent torsional force) to reduce and/or counteract the effect of vibrations that are mechanically coupled into the contact members.

Fig. 13 shows an example in which contact members 972 are spaced at intervals along intermediate structure 976 to achieve a more uniform thermal profile around tip 978. Contact members 972 are also joined to a ring member 992, which effectively functions in a similar manner to central member 970 in Fig. 12. Ring member 992 is connected via contact members 974 to thermal conduit 130. By spacing contact members 972 along intermediate structure 976, the magnitude of any thermal gradients formed in intermediate structure 976 can be reduced.

Methods and systems for coupling dewar 120 to gas field ion microscope system 1100 are further disclosed, for example, in the following PCT applications: Application No. PCT/US2008/067718; and Application No. PCT/US2008/066933.

While certain examples have been described, other examples are also possible.

As an example, while gas field ion sources have been described, other charged particle sources may be used. For example, a liquid metal ion source or an electron source (e.g., an electron microscope, such as a scanning electron microscope) can be used.

As another example, while solid nitrogen has been described, other solid cryogens may be used. Examples include solid neon and solid argon. In some examples, combinations of solid cryogens can be used.

As a further example, while solid cryogens have been described, in certain examples, the cryogen is not solid. For example, in some examples, the cryogen may be in the form of a slurry (e.g., a liquid cryogen containing solid pieces of solid cryogen). A slurry may undergo relatively little boiling because most of the thermal energy absorbed by the slurry would be used to melt the solid portion of the cryogen, as opposed to boiling the liquid portion of the cryogen.

As an additional example, while examples have been described in which a heater is used to melt undesired solid cryogen that blocks liquid nitrogen from reaching the bottom of the dewar, other examples are possible. For example, rather than using a heater to remove solid cryogen, the system can include a timer that causes filling to stop for a period of time (e.g., five minutes or more, ten minutes or more, 15 minutes or more, 20 minutes or more, 30 minutes or more, 40 minutes or more, 60 minutes or more, 80 minutes or more, 100 minutes or more, 120 minutes or more) if there is an indication that the liquid nitrogen cannot reach the bottom of the dewar. During the time when filling is stopped, liquid nitrogen in dewar 120 can melt some or all of the solid nitrogen in dewar 120. As solid nitrogen melts, liquid nitrogen can reach the bottom of the dewar, and the temperature measured by sensor 254 slowly rises. When the measured temperature reaches about 77 K (e.g., the melting temperature of liquid nitrogen), then it is assumed, in certain examples, that the solid nitrogen in dewar 120 has all been melted. After the period of time and/or after it is assumed that all solid nitrogen has melted, another attempt at adding liquid nitrogen to the dewar can be made. In some examples, combinations of one or more heaters and one or more timers can be used.

## Claims

1. A method, comprising:
measuring a temperature of a region of a dewar (120) near a bottom of the dewar (120);
determining whether the temperature of the region of the dewar (120) near the bottom of the dewar (120) is at or above a target temperature; and
adding a liquid cryogen to the dewar (120) if the temperature of the region of the dewar (120) near the bottom of the dewar (120) is at or above the target temperature, **characterized in** the further step of, after adding the liquid cryogen to the dewar (120),
reducing a gas pressure in the dewar (210) to solidify the cryogen.

2. The method of claim 1, further comprising, if the temperature of the region of the dewar (120) near the bottom of the dewar (120) is below the target temperature, heating the dewar (120).

3. The method of claim 2, wherein heating the dewar (120) changes a state of solid cryogen in the dewar (120) to a liquid or a gas.

4. The method of one of the claims 1 - 3, further comprising, if the temperature of the region of the dewar (120) near the bottom of the dewar (120) is above the target temperature, waiting a period of time, and, after waiting the period of time, measuring a first temperature of the region of the dewar (120) near the bottom of the dewar (120).

5. The method of one of the claims 1 - 4, further comprising cooling a charged particle source (110).

6. The method of claim 5, further comprising thermally connecting the charged particle source (110) and the dewar (120)

7. The method of claim 5 or claim 6, further comprising maintaining the charged particle source (110) at a temperature of 80K or less.

## Patentansprüche

1. Verfahren, welches Folgendes umfasst:
Messen der Temperatur eines Gebiets eines Dewarbehälters (120) in der Nähe des Bodens des Dewarbehälters (120),
Feststellen, ob die Temperatur des Gebiets des Dewarbehälters (120) in der Nähe des Bodens des Dewarbehälters (120) bei oder oberhalb einer Zieltemperatur ist, und
Hinzufügen eines flüssigen Kühlmittels zum Dewarbehälter (120), falls die Temperatur des Gebiets des Dewarbehälters (120) in der Nähe des Bodens des Dewarbehälters (120) bei oder oberhalb der Zieltemperatur ist,
**gekennzeichnet durch** den weiteren Schritt des Verringerns des Gasdrucks im Dewarbehälter (210), um das Kühlmittel zu verfestigen, nachdem das flüssige Kühlmittel zum Dewarbehälter (120) hinzugefügt wurde.

2. Verfahren nach Anspruch 1, wobei ferner, falls die Temperatur des Gebiets des Dewarbehälters (120) in der Nähe des Bodens des Dewarbehälters (120) unter der Zieltemperatur ist, der Dewarbehälter (120) erwärmt wird.

3. Verfahren nach Anspruch 2, wobei durch das Erwärmen des Dewarbehälters (120) der Zustand des festen Kühlmittels im Dewarbehälter (120) zu einem flüssigen oder einem gasförmigen Zustand geändert wird.

4. Verfahren nach einem der Ansprüche 1 bis 3, wobei ferner, falls die Temperatur des Gebiets des Dewarbehälters (120) in der Nähe des Bodens des Dewarbehälters (120) oberhalb der Zieltemperatur ist, einen Zeitraum gewartet wird und, nachdem während des Zeitraums gewartet wurde, eine erste Temperatur des Gebiets des Dewarbehälters (120) in der Nähe des Bodens des Dewarbehälters (120) gemessen wird.

5. Verfahren nach einem der Ansprüche 1 bis 4, wobei ferner eine Quelle (110) für geladene Teilchen gekühlt wird.

6. Verfahren nach Anspruch 5, wobei ferner die Quelle (110) für geladene Teilchen und der Dewarbehälter (120) thermisch verbunden werden.

7. Verfahren nach Anspruch 5 oder 6, wobei ferner die Quelle (110) für geladene Teilchen bei einer Temperatur von 80 K oder darunter gehalten wird.

## Revendications

1. Procédé, comprenant :
mesurer une température d'une région d'un vase de Dewar (120) à proximité d'un fond du vase de Dewar (120) ;
déterminer si la température de la région du vase de Dewar (120) à proximité du fond du vase de Dewar (120) est égale ou supérieure à une température cible ; et
ajouter un cryogène liquide au vase de Dewar (120) si la température de la région du vase de Dewar (120) à proximité du fond du vase de Dewar (120) est égale ou supérieure à la température cible,
**caractérisé par** l'étape supplémentaire consistant à, après avoir ajouté le cryogène liquide au vase de Dewar (120), réduire une pression de gaz dans le vase de Dewar (210) afin de solidifier le cryogène.

2. Procédé selon la revendication 1, comprenant en outre, si la température de la région du vase de Dewar (120) à proximité du fond du vase de Dewar (120) est inférieure à la température cible, l'étape consistant à chauffer le vase de Dewar (120).

3. Procédé selon la revendication 2, dans lequel l'étape consistant à chauffer le vase de Dewar (120) transforme un état de cryogène solide dans le vase de Dewar (120) en liquide ou gaz.

4. Procédé selon l'une des revendications 1 à 3, comprenant en outre, si la température de la région du vase de Dewar (120) à proximité du fond du vase de Dewar (120) est supérieure à la température cible, l'étape consistant à attendre pendant un certain temps et, après avoir attendu pendant un certain temps, l'étape consistant à mesurer une première température de la région du vase de Dewar (120) à proximité du fond du vase de Dewar (120).

5. Procédé selon l'une des revendications 1 à 4, comprenant en outre l'étape consistant à refroidir une source de particules chargées (110).

6. Procédé selon la revendication 5, comprenant en outre l'étape consistant à relier thermiquement la source de particules chargées (110) et le vase de Dewar (120).

7. Procédé selon la revendication 5 ou la revendication 6, comprenant en outre l'étape consistant à maintenir la source de particules chargées (110) à une température de 80K ou moins.
